# EUROPEAN PATENT APPLICATION

(11) **EP 0 539 108 A1**
(43) Date of publication of application: **28.04.1993**
(21) Application number: 92309448.6
(22) Date of filing: 16.10.1992
(51) Int. Cl.: B29C 45/27

(54) **Viscosity control channel for a transfer mold having a plurality of mold cavities**

(30) Priority: 24.10.1991 US 782044
(71) Applicant: AT&T Corp., New York, NY 10013-2412 (US)
(72) Inventor: Zimmerman, Michael A., North Andover, Massachusetts 01845 (US)
(74) Representative: Johnston, Kenneth Graham

(57) **Abstract**

The present invention is directed toward a multicavity transfer mold having at least two mold cavities. The first mold cavity is coupled to a runner via a gate and a viscosity controlling channel and the second mold cavity is coupled to the runner, downstream of said first mold cavity, via a second gate and a second viscosity controlling channel. The viscosity controlling channel of the downstream mold cavity is sized to more freely pass molding compound to the second mold cavity than the viscosity controlling channel of the upstream cavity. In operation, the viscosity controlling channels equalizes and optimizes the temperature and, therefore, the viscosity of the molding compound flowing into each cavity. The result is that the resistance for the molding compound as it flows along the runner into each gate and cavity is reduced and the various cavities are filled at equal rates and at lower filling velocities. The substantially identical molding conditions established in each individual cavity with this invention substantially eliminates those defects which are normally attributable to the molding process.

## Description

### Technical Field

This invention relates to molds used in the transfer molding process to encapsulate integrated semiconductor devices coupled to leadframes and, more particularly, to an improved multicavity mold which creates substantially identical molding conditions in each individual mold cavity.

### Background of the Invention

Currently, plastic molding compounds are used to encapsulate a very large percentage of the silicon-integrated devices packaged throughout the world each year. The concept of encapsulating one or more silicon devices within a plastic package has contributed materially to reducing the cost of packaging devices. This, in turn, has led to the use of silicon devices in an ever-increasing army of products.

The development of molding compounds which exhibit low thermal coefficients of expansion and high fracture toughness has enabled transfer molding to be used in high volume production to encapsulate silicon integrated devices. The transfer molding process can be thought of as being comprised of the three distinct phases of A) filling a multicavity mold with molding compound, B) packing the molding compound in the mold, and C) curing the molding compound.

With the transfer molding process, extreme care must be exercised to prevent damage to wire bands on the silicon devices and to the associated leadframe during the encapsulation process.

A study of the prior art process of encapsulating silicon integrated devices damage suggests that the filling and packing phases of the molding process causes flow-induced damage and pressure induced stresses to the silicon device, the leadframe and the connecting wire bands.

This invention is directed toward eliminating these encapsulation-related problems.

### Summary of the Invention

The present invention is directed toward a multicavity transfer mold having at least two mold cavities. The first mold cavity is coupled to a runner via a gate and a viscosity controlling channel and the second mold cavity is coupled to the runner, downstream of said first mold cavity, via a second gate and a second viscosity controlling channel. The viscosity controlling channel of the downstream mold cavity is sized to more freely pass molding compound to the second mold cavity than the viscosity controlling channel of the upstream cavity. In operation, the viscosity controlling channels equalizes and optimizes the temperature and, therefore, the viscosity of the molding compound flowing into each cavity. The result is that the resistance for the molding compound as it flows along the runner into each gate and cavity is reduced and the various cavities are filled at equal rates and at lower filling velocities. The substantially identical molding conditions established in each individual cavity with this invention substantially eliminates those defects which are normally attributable to the molding process.

### Brief Description of the Drawing

The invention is further set forth in the following detailed description taken in conjunction with the appended drawing in which like parts are designated with the like reference numerals throughout the same:
Fig. 1 illustrates a cutaway view of a semiconductor device electrically coupled to leads of a leadframe and encapsulated in plastic;
Fig. 2 illustrates a typical leadframe;
Fig. 3 illustrates molding compound filling a prior art plate mold cavity during the encapsulating process;
Fig. 4 is a schematic view of the runner configuration and mold cavities of a prior art transfer mold for simultaneously encapsulating seventy two devices;
Fig. 5 is a partial schematic view of the runner configuration and mold cavities of a transfer mold assembly in accordance with the principle of the invention;
Fig. 6 illustrates a cutaway sectional view of a mold in accordance with the principle of the invention;
Fig. 7 illustrates a cutaway sectional view of another mold in accordance with the principle of the invention; and
Fig. 8 is a time contour plot of a group of twelve mold cavities of Fig. 4 at 70% fill.

### Detailed Description

Silicon integrated devices, because of their small size and fragile nature are frequently embedded in plastic molding compound and electrically connected to an mary of electrical conductors partially embedded within the molding compound and having ends which project beyond the edge of the assemblage. The ends of the electrical conductors embedded in the plastic molding compound are located close to the silicon device and are known as the inner leads. They are connected to bonding pads on the silicon device through fine wires. The other ends of the leads which project outward from the edge of the assemblage are shaped to form "J" type leads or "gull wing" leads for mounting onto a circuit board.

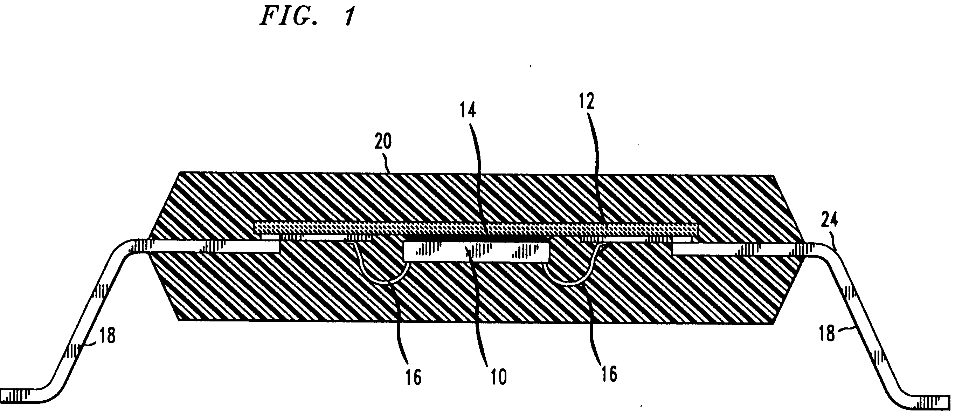

Referring to Fig. 1, there is illustrated a cutaway view of such a semiconductor device supported by a ceramic member and electrically coupled to the leads of a leadframe and encapsulated in plastic. In the illustrated embodiment, a silicon device 10 is secured to a ceramic member 12 by thermally conductive epoxy adhesive 14. The ceramic member 12 supports conductive paths for making electrical connections from the silicon device to the leads 18 of a lead frame 24. Fine wire bands 16 electrically connect the various bond pads on the silicon device 10 to appropriate conductive paths on the ceramic member 12. The conductive paths on the ceramic member 12 are also connected electrically to the inner ends of the various leads 18 of the leadframe 24. In the completed assemblage, the ceramic member 12, silicon device 10, wire bands 16 and inner ends of the leads 18 are embedded within plastic molding compound 20 which provides support and electrical isolation.

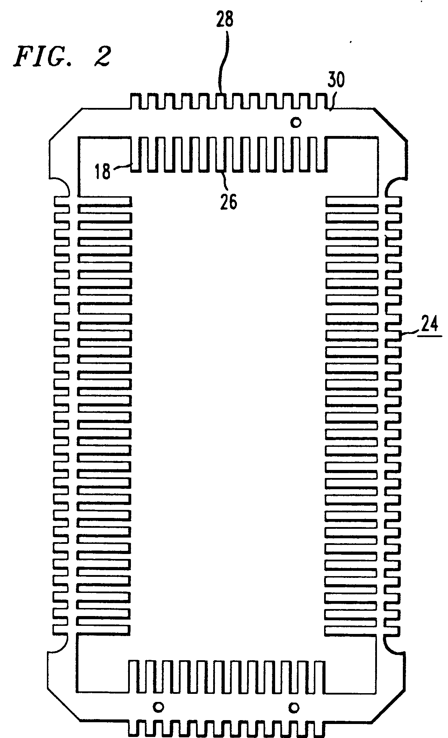

Referring now to Fig. 2, there is illustrated a typical lead frame 24 prior to being attached to the ceramic member 12. The leadframe 24 can be a flat sheet of metal such as copper, copper alloy or the like stamped or etched to form a square or a rectangle of a plurality of conductive leads 18 having inner ends 26 and outer ends 28. The outer ends 28 are attached to a frame support member 30 which holds the various leads 18 in position relative to each other until after the ends 26 of the leads 18 have been connected to the ceramic member 12 and the wire bands 16, and the assemblage has been encapsulated in the plastic molding compound. Following the molding process the frame support member 30 is removed from the leads 18; and, the ends 28 of the leads 18 are formed to their final configuration in a trim and form operation.

One method of forming the final package is by a "post-molding" process. In the process, the leadframe and the attached silicon integrated device is encapsulated by a thermoset plastic molding compound.

The encapsulating material, the molding compound, which is a thermoset polymer molding compound, is one of the most important materials in molded plastic packaging. The molding polymer is converted from a low-viscosity fluid to a hard plastic during the process. Although it has a softening point, or glass transition temperature, it does not flow after polymerization, even at soldering temperatures, because it has a cross-linked molecular architecture.

Epoxy is the cross-linkable resin for nearly all commercial molding compounds. The formulation consists of a mixture of epoxy resin, hardener, catalyst, fillers, flame retardants, flexiblizers, coupling agents, mold release agents and colorants. Important molding compound properties include low viscosity to reduce damage to the fragile assemblies during molding, rapid cure to provide high productivity and low thermal shrinkage forces caused by differences in the coefficient of thermal expansion among the molding compound, the leadframe and the silicon device.

Present day low-stress molding compounds have low coefficient of thermal expansion and low modulus to minimize the stresses generated, excellent strength to resist the cracking these stresses promote, and good adhesion to the silicon device and leadframe to disseminate the stresses over the entire package volume. Normally, the molding compound contains about 75 percent by weight of inorganic filler, e.g., ground silicon to lower the coefficient of thermal expansion and increase thermal conductivity.

Almost all post-molded plastic packages are made by the transfer molding process using thermoset molding compounds. In this process, an assembled leadframe is loaded in a mold cavity either manually or with an automated leadframe loader and the mold is then placed in an oven where it is preheated. The molding compound is pre-softened by heating it in a dielectric preheater above its glass transition temperature. The operation is started by forcing the heated molding compound out of a transfer pot and into either the top or bottom portion of the preheated mold cavity. After the mold is filled, the pressure is increased to pack and further polymerized the molding compound under a higher applied pressure. Packing is important because the material is porous after filling. Packing compresses both macroscopic and microscopic voids in the molded body and lowers package permeability to eliminate voids where water can collect and promote corrosion. The plastic molding compound generates flow-induced stresses on the fragile silicon device, the connecting wires and the leads as it fills the cavity. This flow-induced stress can cause damage and yield loss.

The flow of the molding material and its subsequent past properties after molding are a function of the process profile, i.e., pressure, temperature, velocity, time; the deformation and flow characteristics of the molding material, and the features and geometrics of the mold.

The transfer molding process can be considered to be comprised of three distinct phases identified as filling, packing, and curing. The types of defects which commonly occur during molding include incomplete fills; voids - air bubbles from incomplete venting; blisters - air bubbles remaining at the surface; pinholes - voids which are open at the surface; and various forms of internal device damage.

Two types of internal device damage includes wire sweep which is caused by flow-induced stress due to viscous drag and surface tension effects; and, leadframe and wire damage due to excessive molding pressure or material forces in the individual cavities of a multicavity mold.

The extent to which the above noted defects occurs is dependent on the many interrelated design and process variables which include pressures, temperatures, flow rates and flow directions, along with material rheology including its time and temperature viscosity dependent characteristics and its rate of reaction.

Clearly, flow-induced device damage and pressure-induced stresses, each of which depend on kinematics and the material properties at the instant of contact can be major causes of encapsulation related defects. Normally, velocities of the encapsulating material are typically low enough not to cause these forces to be too high. But, it is believed that the viscosity of the molding compound can increase substantially as a result of low temperature or high conversion thus subjecting the semi-conductor device, the associated wires and the leadframe to damage causing forces.

To minimize component damage, it is necessary to minimize the viscosity, pressure, and velocity of the molding compound. Competing with these criteria are appropriate ranges of parameters required to both minimize other defects such as voids and to provide process ranges which will optimize the performance of the epoxy resin. And, all of this must be done, not in one, but in each cavity of a production mold simultaneously to produce parts which have equally high quality properties.

The first step in the molding of a thermoset material is to heat both the multicavity mold assemblage and the material. The material is heated to its softening point, normally with a dielectric heater. The softening temperature is near 90 ° C for epoxy resins. The preheated molding material is then delivered to runners in the runner plate of a plate mold. The molding material then travels through the runner system in a way that distributes the material to all of the cavities of the mold. Prior to entering the mold cavity, the molding material passes through a narrow opening called a gate. Air escapes from the mold cavities through small vents.

Thermoset molding is characterized by the fact that the mold is preheated to a temperature which is much higher than the temperature of the incoming molding material. Thus, as the molding material flows through the runner system and the gates, it increases in temperature. The amount of heat transferred to the molding compound and, therefore, the temperature of the molding compound as it enters the mold cavity is dominated by conduction and frictional heating of the molding compound as it moves along the runners and through the gates of the mold. Thus, as the molding material travels through the runners, its temperature increases and its viscosity changes.

As a function of time, the viscosity of the heated material goes through a minimum and begins to increase as the material cures. The precise viscosity vs. time curve depends principally on the temperature and shear rate of the material.

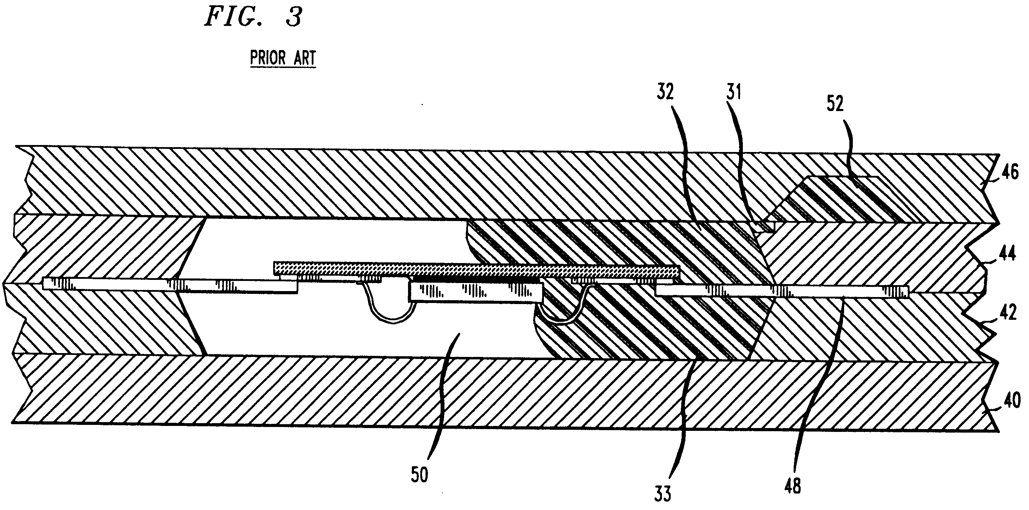

Referring to Fig. 3, there is illustrated a prior art mold cavity of a plate mold as it is being filled with molding compound dig the encapsulation process. The mold is comprised of four plate members more fully identified as a base plate member 40, a bottom aperture plate member 42, a top aperture plate member 44, and a runner plate member 46. When assembled, the four members 40, 42, 44 and 46 are positioned one on top of another as illustrated in Fig. 3. The silicon device and leadframe which is to be encapsulated is held captive within the mold cavity by the bottom aperture member 42 and the top aperture member 44. More specifically, the edges of the leadframe are positioned within relief areas 48 located within the bottom aperture member and top aperture member around the perimeter of the mold cavity. The runner member 46 and base member 40 define a bottom and top surface of the mold cavity 50; and the top and bottom aperture members 44, 42 define the sides of the mold cavity. The runner member 46 supports at least one runner 52 which is a channel for directing molding compound from an input port to the mold cavity 50. The top aperture member 44 supports a gate 31, a channel through which molding compound flows into the cavity 50 of the mold from the runner 52.

It is to be noted that in a conventional mold there are two members instead of the four members of a plate mold. In the conventional mold, the runner, the gate, and one-half of the mold cavity are located in the top member. The other one-half of the mold is located in the bottom member.

During the encapsulation process, molding compound flows from the runner 52, through the gate 31 and into the mold cavity 50. The molding compound enters the cavity at a point located either above or below the leadframe. After entering the cavity, the molding compound divides into two flow parts. A first flow part 32 can be located above the leadframe; and, a second flow part 33 flows through openings in the leadframe to fill the mold cavity beneath the leadrame. The top and bottom flow parts advance toward the far end of the mold cavity.

The fronts of the top and bottom flow parts usually advance at different rates based on cavity thicknesses and process conditions. The location where the flow fronts meet is called a weld or nit line. The weld line is an area of local weakness and can act as a stress concentration. The properties of the weld line are proportional to the pressures and temperatures of the converging flow fronts.

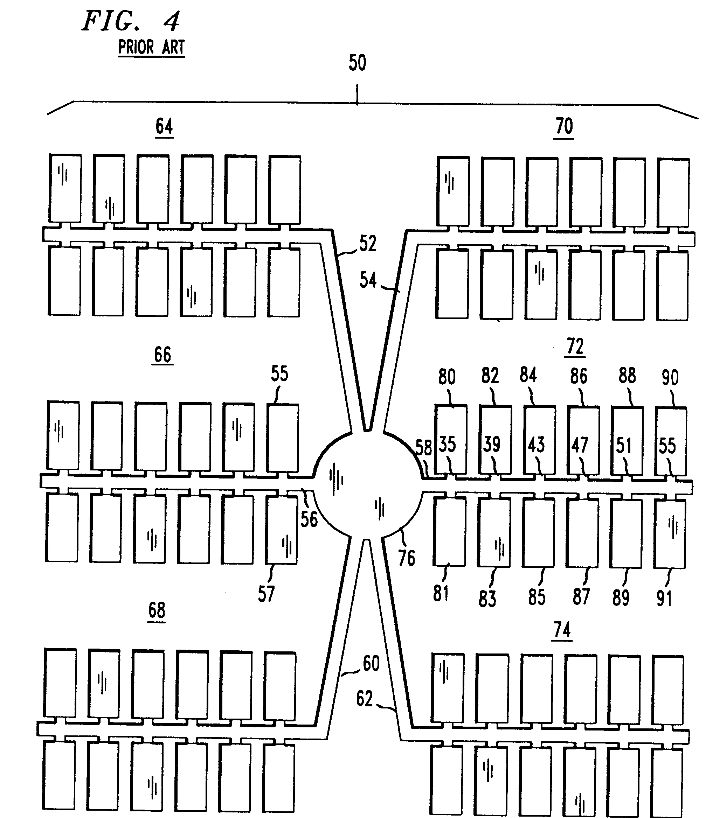

Referring to Fig. 4, there is a schematic view of a prior art transfer mold assembly 50 having runners 52-62 configured to direct molding compound to six groups of mold cavities 64-74 where each group consists of twelve separate mold cavities. In operation, molding material passes from a receiving port 76 to runners 52-62 which can be of various length. Each runner of the mold of Fig. 4 is coupled to direct molding compound to twelve mold cavities via individual gates.

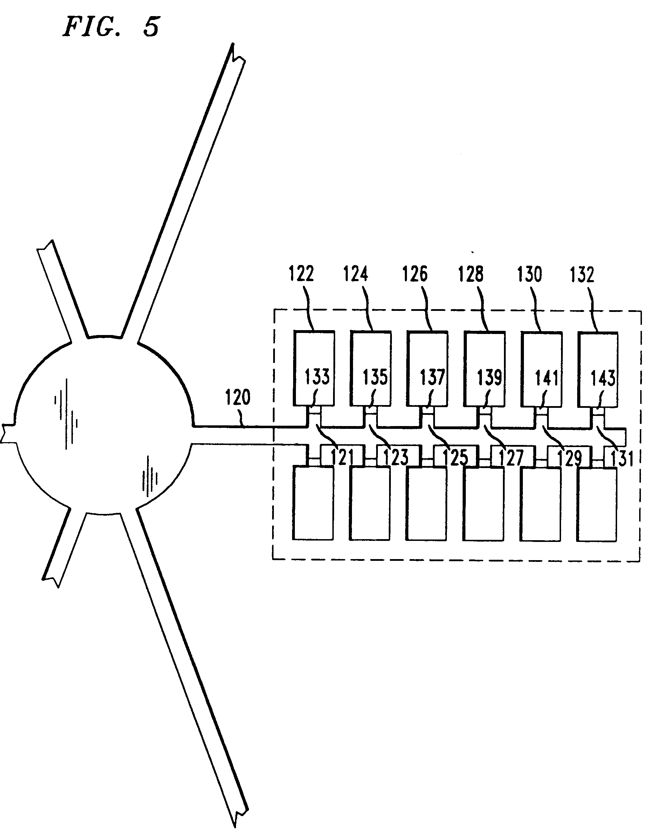

Referring to Fig. 5, there is illustrated a schematic view of a runner and connecting mold cavities of a transfer mold assembly in accordance with the principle of the invention. The inventive transfer mold assembly comprises a viscosity control channel interposed between a runner 120 and each of a plurality of mold cavities. The viscosity control channels balance the temperature of the molding compound as it flows into the various mold cavities from a common runner.

Specifically, a viscosity control channel is positioned between the runner and the gate of each of the various mold cavities coupled to that runner. The viscosity control channel substantially equalizes the temperature and therefore the viscosity of the molding compound as it flows into each cavity. Referring to Fig. 5, a double set of mold cavities are coupled to a common runner. Referring to the upper set of mold cavities, viscosity control channels 121, 123, 125, 127, 129, 131 of mold cavities 122, 124, 126, 128, 130, 132 are coupled to receive molding compound from the common runner 120. Gates 133, 135, 137, 139, 141 and 143 are located between the viscosity control channels and the mold cavities. Starting from the first-to-occur downstream viscosity control channel, and proceeding downstream, the viscosity control channels have geometries which are proportionately larger. It has been found that the proportionately larger control channels equalize the temperature and, therefore, the viscosity of the molding compound as it flows into the mold cavities. Thus, with this invention, the viscosity of the molding compound which flows into each cavity is substantially equal.

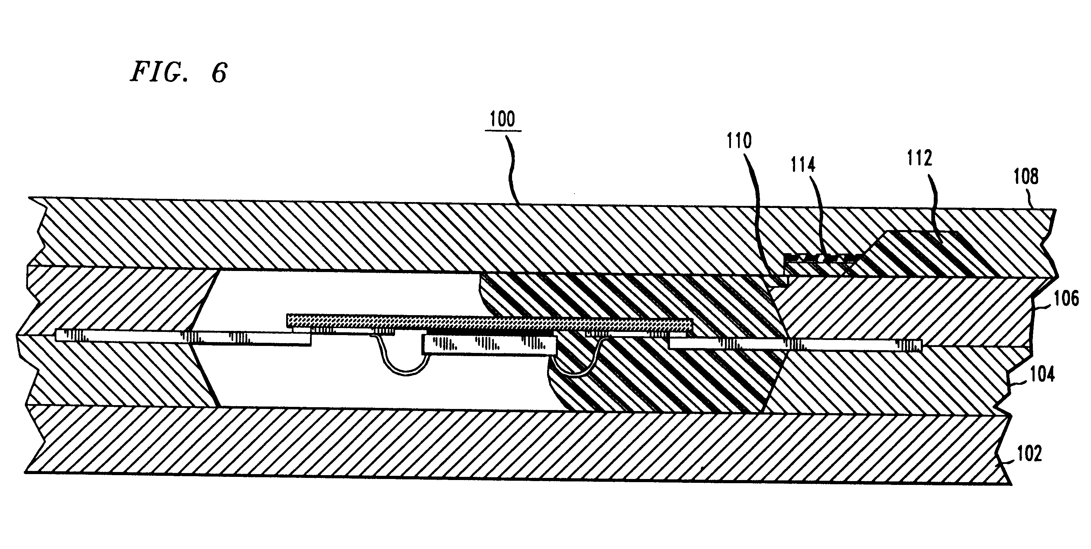

Referring to Fig. 6, there is illustrated a cross sectional view of a mold cavity of a transfer plate mold in accordance with the principle of the invention. In the plate mold illustrated in Fig. 6 a viscosity control channel is located in the runner plate member. More specifically, the mold 100 consists of four plate members more fully identified as a base plate member 102, a bottom aperture plate member 104, a top aperture plate member 106, and a runner plate member 108. The top aperture plate member 106 supports a gate 110; and, the runner plate member 108 support a runner 112 and a viscosity control channel 114. When the four plate members 102, 104, 106, 108 are assembled one on top of another to form the mold 100, the viscosity control channel 114 is positioned to pass molding compound from the runner 112 to the gate 110.

In a mold design as illustrated in Fig. 5 where each runner directs molding compound to a double row of six mold cavities, the geometries of the viscosity control channels 121, 123, 125, 127, 129, 131 for the mold cavities 122-132 are sized to equalize the temperature of the molding compound which flows into each of the various mold cavities. More specifically, viscosity control channel 121 for mold cavity 122 is designed to have a depth of .030˝, viscosity control channel 123 for mold cavity 124 is designed to have a depth of .035˝, viscosity control channel 125 for mold cavity 126 is designed to have a depth of .040˝, viscosity control channel 127 for mold cavity 128 is designed to have a depth of .045, viscosity control channel 129 for mold cavities 130 is designed to have a depth of .050, and viscosity control channel 131 for mold cavity 132 is designed to have a depth of .055˝. In the embodiment disclosed, in each instance the widths and lengths of the various viscosity control channels are of the same dimensions and the depths vary. Obviously, geometric variations are not restricted to the depth, but can be made to the width, length and/or depth of the various viscosity control channels. In addition, the gates to each of the mold cavities can have similar geometries. In the operation of the inventive mold, the molding compound flowing into each mold cavity has a more uniform flow profile and a lower velocity. Pressure drops of the molding compound across the viscosity control channel-gate combination for the various mold cavities were, for the first-to-occur mold cavity 122 to the last-to-occur mold cavity 132: 842 psi, 745 psi; 652 psi; 580 psi; 523 psi; and 484 psi. The pressure drop required to push the molding compound along the runner from the first-to-occur viscosity control channel 122 to the last-to-occur viscosity control channel was 371 psi. Thus, the molding compound filled the runner before filling of the cavities. The progressive geometry change of the viscosity control channels is responsible for equalizing the viscosity of the molding compound which flows into each mold cavity coupled to a common runner by balancing the temperature of the molding compound which flows into the mold cavities.

It was observed that the temperature change of the molding compound along the runner was 11.6°C. The progressive geometric variation of the viscosity control channels compensates for the increase of temperature of the molding compound as it advances to the last-to-occur or upstream mold cavities. The maximum temperature difference between the molding compound entering any mold cavity was observed to be 13.7°C. This is lower than the temperature differential experienced with prior art multi-cavity molds, which is normally greater than 20°C.

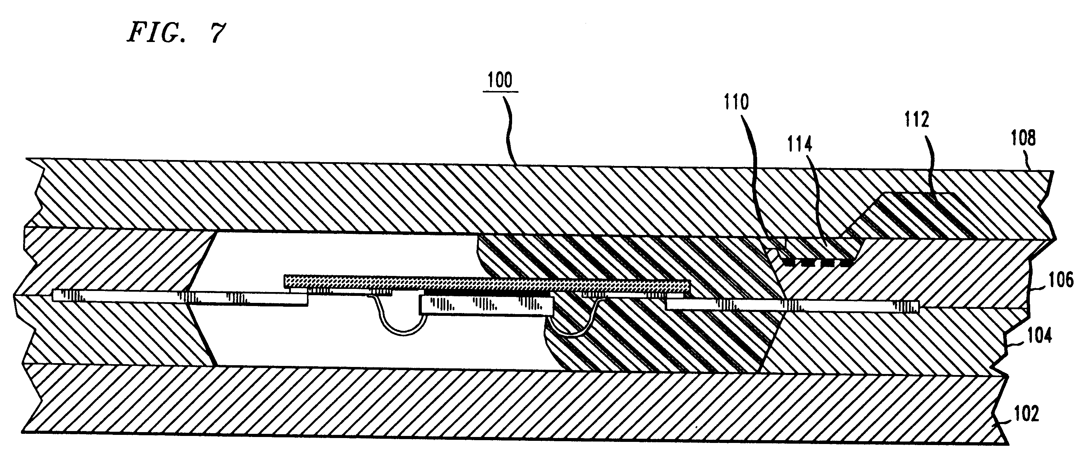

Referring to Fig. 7, there is illustrated another embodiment of the invention. More specifically, the viscosity control channel is located in the top aperture plate member. Thus, the top aperture plate member 106 supports a gate 110 and viscosity control channel 114; and the runner plate member 108 supports a runner 112. When the four plate members 102, 104, 106, 108 are assembled one on top of another to form the mold 100, the viscosity control channel 114 is positioned to pass molding compound from the runner 112 to the gate 110.

It is to be understood that the use of viscosity control channels to equalize the the temperature and, therefore, the viscosity of molding compound which flows into the cavities of a multicavity mold is not limited to a multicavity plate mold, but can be used with other types of multicavity molds.

It is believed that devices encapsulated with prior art transfer plate molds experienced encapsulation related problems because the molds are extremely sensitive to process parameters. One reason for this is that the molding material has different temperatures and shear histories immediately prior to entering each cavity of a group of mold cavities. For example, referring to Fig. 4, the molding compound which enters mold cavity 80 picks up heat from the hot mold as it travels from receiving port 76 to the gate 35 of cavity 80 and has a different history than the molding compound which enters mold cavity 84 which is heated to a higher temperature because it is in the runner for a longer duration; and these histories are different than that of the molding compound which enters mold cavity 90 which is heated to subjected to additional heating while moving to the furtherest most cavity. In addition, the gates of the various cavities are identical in size and, therefore, the molding compound encounters increasing resistance as it moves down the runner. Furthermore, the molding compound which enters the mold cavities of group 68 have histories which are again different from the histories of the compound which enters the mold cavities of group 72 because the different lengths of runners 58 and 60.

Numerous semiconductor devices encapsulated with the prior art mold of Fig. 4 sustain substantial damage to their wire bands when recommended process parameters are used. In particular, the leadframes of devices located in the first mold cavities 80, 81 of the various groups of mold cavities suffered from encapsulation related defects.

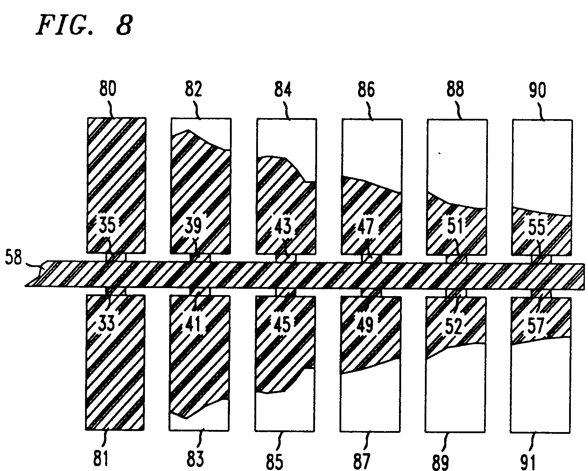

Referring now to Fig. 8, there is illustrated a view of our understanding of mold cavities 80-91 of the group of mold cavities 72 of a prior art mold receiving molding compound from runner 58 and associated gates 33-57 at 70% fill time of the cycle. An analysis of Fig. 8 suggests that the mold cavities 80, 81 which are the first to receive molding compound are the first to fill; and the mold cavities 90, 91 which are at the end of the runner are the last to fill. This progressive filling of the mold cavities is known as the "christmas tree" phenomena.

A study of the molding process suggests that the devices experience damage dig the encapsulation process because the temperature of the molding compound is higher at the down stream cavities than at the up stream cavities. Remembering that the molding compound temperature increases as it travels along the runner, the molding compound which enters the first mold cavity 80 of a group 72 of cavities will be colder than the molding compound which enters the last mold cavity 90 of that group of mold cavities. In addition, in a mold, the pressure drop required to push the molding compound from the upstream end of runner 58 into each mold cavity was determined to be: 204 psi for mold cavities 80, 81; 233 psi for mold cavities 82, 83; 334 psi for mold cavities 84, 85; 363 psi for mold cavities 86, 87; 217 psi for mold cavities 88, 89; and, 187 psi for mold cavities 90, 91. Thus, different pressures are required to cause the molding compound to enter each next occurring cavity. But, the molding compound will normally flow along the path of least resistance. Thus, when the molding compound arrives at gate 35 of cavity 80, the molding material will first flow into and substantially fill mold cavities 80,81 because this is the path of least resistance. It is only after cavities 80,81 are partially filled that the molding compound will flow further along the runner to the next occurring gates. The molding compound which flows past gate 35 toward gate 39 is in runner 58 for a longer time and, therefore, is further increased in temperature. Clearly, therefore, the viscosity of the molding compound which enters mold cavity 80 is different than the viscosity of the molding compound which enters mold cavity 82. It is our understanding that it is this difference in viscosity which causes the pressure imbalance which leads to the christmas tree effect. Wire sweep damage is a function of the product of the velocity times the viscosity of the material inside a mold cavity. The high pressure needed to force the molding compound into the molds suggests that the material in the cavity will have a high viscosity. In addition, a substantial quantity of the material in the runner 58 is directed into and fills the first three cavities 80, 82, 84 well in advance of the last to occur cavities. This suggests that the fill velocities for the first mold cavities 80,81 will be high. Thus, the first mold cavities 80, 81 will be very sensitive to wire sweep damage.

The temperature effects in the prior art mold were found to be significant. It was determined that the temperature rise across gate 35 is a minimum of 16.3°C and the temperature rise downstream along the runner from the first gate 35 to the last to occur gate 90 of mold cavity 90 is 20°C. Thus, there is a clear viscosity imbalance between the material which enters the six tandemly positioned cavities 80, 82, 84, 86, 88 and 90.

Since the material is a thermoset, its properties at the completion of the molding process are affected by its temperature and time histories. In this case, it is apparent that the temperature - time profile of the molding compound which fills a first to occur mold cavity will be very different from that of the molding compound which fills the last to occur mold cavity. This differential of viscosity causes the properties of the devices molded in the first cavity to be different from those of the last cavity.

What has been described is merely illustrative of the application of the principle of the present invention. Other arrangements and methods can be implemented by those skilled in the art without departing from the spirit and scope of the present invention.

## Claims

1. A transfer mold comprising
means defining a runner for receiving heated molding compound from a feed port,
means defining a plurality of mold cavities, and
means for channeling the heated molindg compound from the runner to the cavities,
the channeling means including a plurality of viscosity control channels each channeling the heating molding compound to a respective one of the cavities, the viscosity control channels having respective geometries such that the molding compound has substantially the same viscosity entering each of the cavities.

2. A transfer mold comprising
a feed port for receiving heated molding compound,
means defining a runner for receiving said molding compound from said feed port,
means defining first mold cavity coupled to receive molding compound from said means defining a runner,
means defining a second mold cavity coupled to receive molding compound from said means defining a runner downstream from said first mold cavity defining means,
a first gate means coupled to said first mold cavity defining means and said runner defining means for admitting molding compound into said first mold cavity defining means,
a second gate means coupled to said second mold cavity defining means and said runner defining means downstream of said first gate means for admitting molding compound into said second mold cavity defining means,
a first viscosity control channel interposed between said first gate means and said runner defining means, and
a second viscosity control channel interposed between said second gate means said said runner defining means,
said first and second viscosity control channels being adapted to balance the viscosity of the molding material which enters the first and second mold cavity defining means.

3. The transfer mold of claim 2
wherein said first and second viscosity control channels have different geometries.

4. The transfer mold of claim 3
wherein the first viscosity control channel is sized to provide a greater pressure drop to molding compound flowing there through than the pressure drop of molding compound flowing through the second viscosity control channel.

5. The transfer mold of claim 3
wherein
said first viscosity control channel has a cross sectional area which is less than that of said second viscosity control channel.

6. The transfer mold of claim 3
wherein
said first gate means and said second gate means have similar geometries.

7. The transfer mold of claim 6
wherein said transfer mold comprises a runner member and a top aperture member adapted to cooperate with said runner member to define a first surface and a portion of the sides of a mold cavity,
said runner member having a first passageway which defines said runner, means
said runner member having second and third channels which define said first and second viscosity control channels, and
said top aperture member having first and second channels which defines said first and second gate means.
